Europäisches Patentamt

European Patent Office

Office européen des brevets

(19)

(11) Publication number: **0 021 661**
**B1**

(12) **EUROPEAN PATENT SPECIFICATION**

(45) Date of publication of patent specification: **14.03.84**

(51) Int. Cl.³: **H 01 L 27/02, H 01 L 23/52**

(21) Application number: **80301878.7**

(22) Date of filing: **05.06.80**

(54) Semiconductor master-slice device.

(30) Priority: **07.06.79 JP 71533/79**

(43) Date of publication of application:
**07.01.81 Bulletin 81/1**

(45) Publication of the grant of the patent:
**14.03.84 Bulletin 84/11**

(84) Designated Contracting States:
**DE FR GB NL**

(56) References cited:
EP - A - 0 001 164
EP - A - 0 001 209
US - A - 3 795 973

(73) Proprietor: **FUJITSU LIMITED**
**1015, Kamikodanaka Nakahara-ku**
**Kawasaki-shi Kanagawa 211 (JP)**

(72) Inventor: **Ohba, Osam**
**536-5-2-303, Ohmaru**
**Inagi-shi Tokyo 192-02 (JP)**
Inventor: **Sato, Shoji**
**6203-23-234, Tana**
**Sagamihara-shi, Kanagawa 229 (JP)**
Inventor: **Aihara, Satoshi**
**537, Kamiyabe**
**Sagamihara-shi, Kanagawa 229 (JP)**

(74) Representative: **Abbott, Leonard Charles et al,**
**GILL JENNINGS & EVERY 53-64 Chancery Lane**
**London WC2A 1HN (GB)**

Courier Press, Leamington Spa, England.

(56) References cited:

IBM TECHNICAL DISCLOSURE BULLETIN, vol.
20, July 1977, New York, USA J.Z. CHEN et al.
"Off-chipgrou nd-up receiver", pages 613-614
PROCEEDINGS OF THE NATIONAL
ELECTRONICS CONFERENCE, vol. 32, October
1978, New York, USA E.A. SLUTZ and W.M.
VANCLEEMPUT: "Structured integrated circuit
design with the HIDRIS system", pages 123-128
Review of the Electrical Communication
Laboratories, volume 26, numbers 9-19, Sept.-
Oct. 1978, pages 1355-1366
PATENTS ABSTRACTS OF JAPAN, vol. 3,
January 11, 1979, Tokyo, JP page 60 E 82
IBM TECHNICAL DISCLOSURE BULLETIN, vol.
21, February 1979, New York, USA Y. BONNET:
"Connection of PNP transistors in master slices",
pages 3655-3656
PATENTS ABSTRACTS OF JAPAN, vol. 3,
February 28, 1979, Tokyo, JP page 78 E 94

The present invention relates generally to a semiconductor device and, more particularly, to a semiconductor integrated circuit manufactured by using master slice technology.

In general, in a large-scale integrated semiconductor device (hereinafter referred to as an LSI) of complex logic, customers may request the requirements of a preferred design. Therefore, there are a large number of kinds of logic LSI's which are dependent upon the requirements of the customers. Accordingly, when the designer designs logic LSI layout patterns, in accordance with each of the requirements of the customers, the LSIs' design time is long and, in addition, the LSIs' manufacturing cost is high.

Therefore, for logic LSIs, it is essential to use a standard layout pattern in order to obtain a fast design time and a low manufacturing cost. Several approaches have been taken to meet this requirement for logic LSIs. One approach is a master-slice technology in which a plurality of unit cells each of which comprises common circuit elements, such as transistors, diodes or resistors and interconnections within the unit cells for connecting the circuit elements to each other are manufactured by using a standard layout pattern and, after that, external connections between the unit cells are manufactured by using a custom-made layout pattern. Usually, the standard layout pattern includes masks for diffusion processes and masks for fixed metal connection, while the custom-made layout pattern includes masks for metal connection processes. Therefore, a large number of kinds of logic LSIs can be produced by selecting a standard layout pattern and changing a custom-made layout pattern, i.e., masks for metal connection processes.

By way of example, European Patent Application No. 1209 discloses an integrated circuit using a wiring pattern made of two layers of metallization and including active unit cells and cells used solely for interconnecting other active unit cells, and conductive lines passing between the active cells, including a greater number of conductive lines in the centre of the chip than on the edge of the chip.

Logic LSI's are usually designed with the aid of a computer; computer-aided design (CAD) predetermines an imaginary grid which is a network of equally-spaced lines forming rectangles. The external connections between unit cells are then aligned with the imaginary grid and the arrangement is programmed so as to optimize the use of the space between unit cells. Japanese Laid-Open Patent Application No. 53-127285, abstracted in Patents Abstracts of Japan, vol. 3, January 11th, 1979, Page 60 E 82, discloses such a logic LSI manufactured by master-slice technology. A plurality of unit cells is arranged in an array, each cell having circuit elements some of which in some cells are interconnected within the cell. The external connections between cells are aligned with selected lines from a first predetermined pattern or grid. Some of the unit cells are not active but are used instead for interconnecting other active unit cells, by means of bypass connections within the cell from edge to edge, using cell areas unallocated for the circuit elements. These bypass connections are also aligned with a predetermined pattern.

Even in this device, some areas within the inactive or bypassing unit cells are wasted, since no such cell has any active part; it has been considered impractical to design an LSI to use the same unit cell for both bypassing and active functions, due to the possible electrical interference of the interconnections, the active circuit elements and the used bypass connections.

It is therefore an object of the invention to further increase the integration of an LSI chip by utilizing more areas of the unit cells while still avoiding any electrical interference.

The invention consists in a semiconductor device manufactured by master-slice technology comprising: a cell array consisting of a plurality of unit cells each of which includes circuit elements; interconnections within some at least of the unit cells, which connect the circuit elements of a unit cell to each other; and external connections outside the unit cells, which connect the unit cells to each other, the external connections being formed in alignment with selected lines from a first predetermined pattern by using some external connection area lying outside the unit cells; the device further comprising bypass connections within some at least of the unit cells for connecting others of the unit cells to each other, the bypass connections in each unit cell using unallocated cell area and being formed in alignment with selected lines from a further predetermined pattern; the device being characterised in that: the unallocated cell area is a portion of a cell wherein circuit elements may simultaneously be used for forming an active unit cell; and in that the first predetermined pattern and the further predetermined pattern are formed in alignment with selected lines of a first predetermined grid and with a further predetermined grid, respectively, which do not coincide.

The fact that the first and further predetermined grids are non-coincident ensures that the bypass connections do not interfere with the interconnections and circuit elements within a unit cell because the former are formed in alignment with one grid and the latter are formed in alignment with the other grid. Connection at the unit cell edges is achieved preferably by L-shaped conductive pieces to compensate for the non-coincidence of the grids.

The present invention will be more clearly understood from the description set forth below with reference to the accompanying drawings.

Fig. 1 is a layout diagram illustrating an example of a basic unit cell without interconnections;

Fig. 2 is a layout diagram of the basic unit cell of Fig. 1 including bypass connections, according to the present invention;

Figs. 3A, 3B and 3C are circuit diagrams illustrating logic circuits which are formed in the basic unit cell of Fig. 1;

Figs. 4A, 4B and 4C are layout diagrams illustrating the logic circuits of Figs. 3A, 3B and 3C, respectively;

Figs. 5A, 5B and 5C are layout diagrams of the logic circuits of Figs. 3A, 3B and 3C, respectively, including bypass connection areas, according to the present invention;

Figs. 6A, 6B and 6C are layout diagrams illustrating the logic circuits of Figs. 3A, 3B and 3C, respectively, including external connections, interconnections and bypass connections;

Fig. 7 is a layout diagram illustrating a unit cell combination according to the present invention;

Figs. 8, 9 and 10 are layout diagrams illustrating three examples of Fig. 7, including interconnections and bypass connections, according to the present invention; and

Fig. 11 is a flow diagram illustrating steps of a computer-aided design according to the present invention.

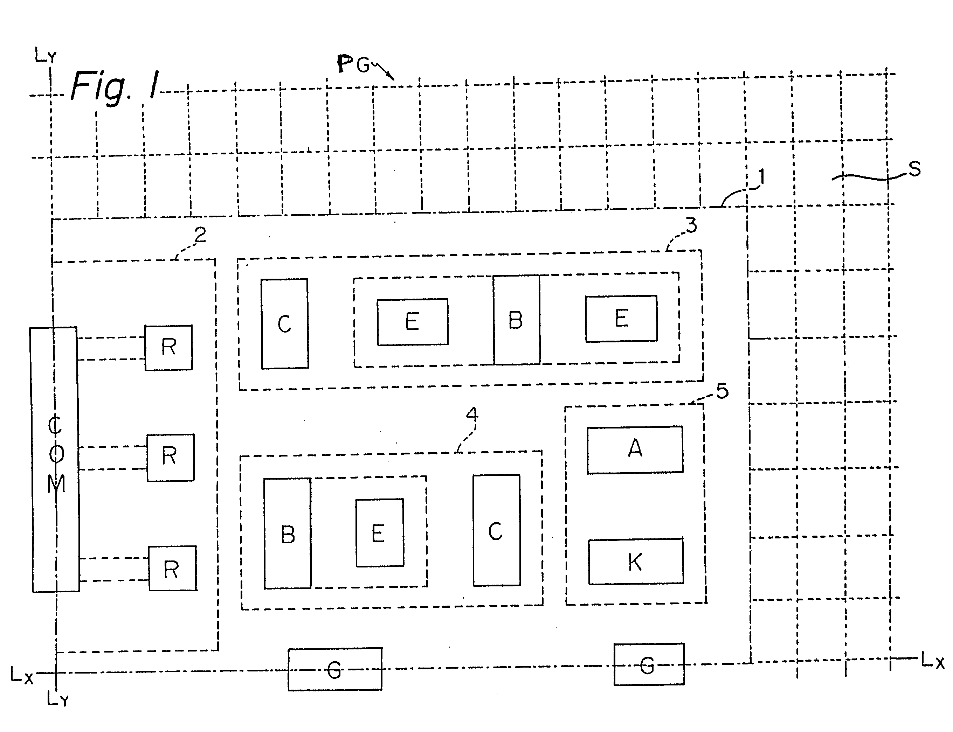

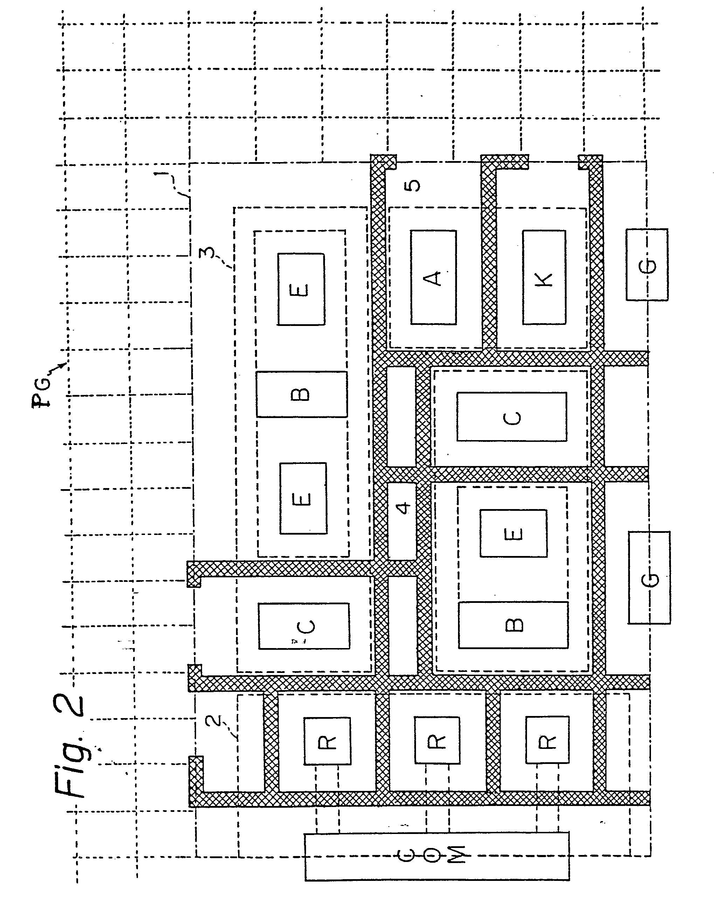

Referring to Fig. 1, which illustrates an example of a basic unit cell, a unit cell 1 comprising resistor elements 2, transistor elements 3 and 4, and a diode element 5 which are arranged not in accordance with a predetermined grid PG which is a network of equally spaced lines forming rectangles is shown. The contact areas as illustrated in Fig. 2 are defined as follows.

"R": resistor contact
"C": collector contact
"B": base contact
"E": emitter contact
"A": anode contact
"K": cathode contact
"COM": common electrode pad of power supply line (Vcc)
"G": electrode pad of ground line (GND)

An LSI including a plurality of such unit cells can be manufactured by using conventional semiconductor technology and master-slice technology. In other words, circuit elements, such as transistors including collector regions, base regions and emitter regions, diodes including anode regions and cathode regions, and resistors are manufactured by selectively introducing impurities into a silicon semiconductor substrate. After that, an insulating layer is deposited on the substrate. Further, two or more metal wiring layers which connect one of the circuit elements to another, and/or connect one of the unit cells to another are deposited.

In an embodiment of the present invention, one part of the external connections, one part of the interconnections, one part of the bypass connections and the power supply lines (Vcc) are formed by a first (lower) wiring layer, while the other part of the external connections, the other part of the interconnections and the other part of the bypass connections and the ground lines (GND) are formed by a second (upper) wiring layer. The external connections formed by the first wiring layer are arranged in row and column directions in accordance with a predetermined grid between the unit cells. In addition, the external connections formed by the second layer can be also arranged in row and column directions in accordance with the predetermined grid between the unit cells. Of course, in this case, accidental shorts between the external connections and the supply lines (or the ground lines) are avoided. In addition, the interconnections formed by the second wiring layer are arranged in accordance with the designers technique. Further, the bypass connections are arranged in accordance with a further grid which is of a different type from the predetermined grid. A preferable arrangement of the circuit elements can be determined by the designer.

In Fig. 1, the resistor elements 2 are arranged next to the lines $L_Y$—$L_Y$. In addition, a common electrode pad COM is arranged on the lines $L_Y$—$L_Y$. Since the resistor elements 2 are connected to the power supply line, it is preferable that the elements 2 are arranged in the proximity of the power supply line. It should be noted that the common electrode pad COM serves also as a common electrode pad of an adjacent unit cell (not shown) symmetrical to the unit cell 1 with regard to the lines $L_Y$—$L_Y$. The transistor element 4 and the diode element 5, which serve as output stages, are arranged next to the lines $L_X$—$L_X$ along which a ground line is arranged. In addition, two electrode pads for the elements 4 and 5, respectively, are arranged. It is also preferable that the elements 4 and 5 are arranged in the proximity of the ground line, since the elements 4 and 5 are often grounded. It should be noted that the electrode pads G also serve as electrode pads of an adjacent unit cell (not shown) symmetrical to the unit cell 1 with regard to the lines $L_X$—$L_X$.

The transistor element 3, which serves as an input stage, is arranged next to a connection area S in which external connections can be arranged. It is preferable that the element 3 is arranged in the proximity of the area S, since the element 3 receives input signals from external connections which are arranged in the area S. The diode element 5 is also arranged in the proximity of the area S, since in a circuit arrangement, the diode element 5 is arranged closer to an output terminal than the transistor element 4. In addition, the arrangement of the collector contact, the base contact and the emitter contact of the transistor elements 3 and 4, and the anode contact and the cathode contact of the diode 5 is determined in order to obtain the shortest external connections.

Figs. 1, 2, and 4 through 10 are depicted by a plotter which is connected to a computer controlled by using a graphic display. The arrangement of external connections, interconnections and bypass connections is designed by the computer so that the paths of these connections are as short as possible which serves to increase the operation speed of the LSI and, in addition, the number of bent portions of these connections are as small as possible which serves to improve the manufacturing yield of the LSI. Further, the LSI can be designed economically and efficiently with the aid of a computer.

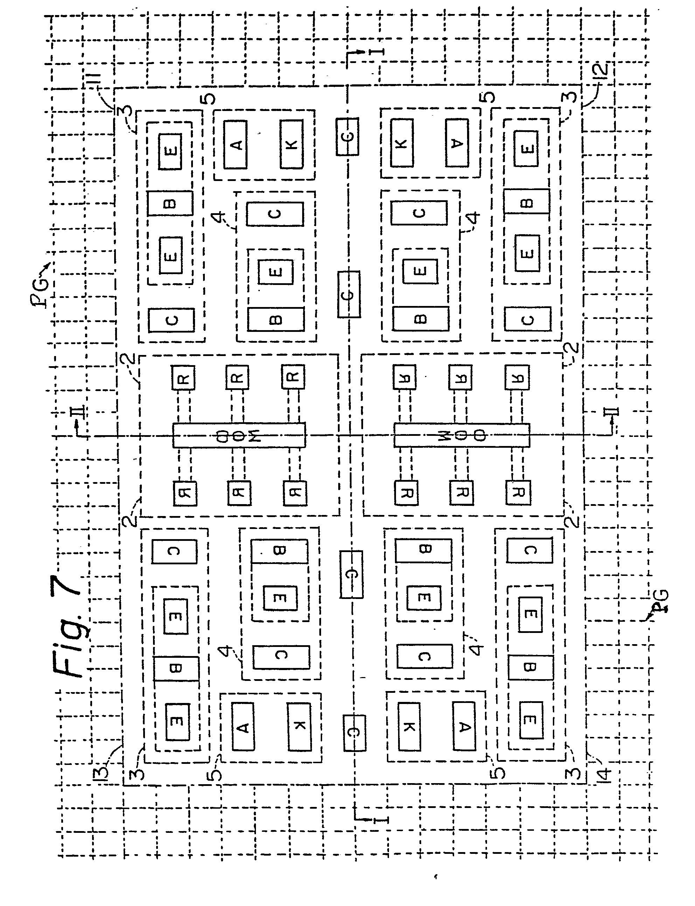

In Figs. 7 through 10, which illustrate combinations of a plurality of unit cells, for a logic circuit, the preferable mutual arrangement of the unit cells is also designed with the aid of a computer, so that the paths of connections are as short as possible and the number of bent portions thereof is as small as possible.

In Fig. 1, if the unit cell 1 is unused, no interconnections are arranged between the circuit elements 2, 3, 4 and 5, so that the wasted area of the unit cell 1 is large. Contrary to this, if the unit cell 1 is used, interconnections are arranged between the circuit elements 2, 3, 4 and 5, so that the wasted area is small. In both cases, it is almost impossible to arrange bypass connections, which pass through the unit cell 1, in accordance with the grid PG, since the paths of the bypass connections are hindered by the circuit elements. In the present invention, such bypass connections are arranged in accordance with a further grid which is a different type from the grid PG. For example, the further grid is determined by the arrangement of circuit elements of each of the unit cells. In addition, the further grid can be determined with the aid of a computer, which is not difficult. The further grid is composed of only the lines necessary for connecting a start point and an end point of a given bypass connection.

Fig. 2 is a layout diagram of the basic unit cell of Fig. 1 including paths of bypass connections, according to the present invention. In Fig. 2, the unit cell 1 is supposed to be unused and, accordingly, no interconnection is arranged. In Fig. 2, cross-hatched portions indicate paths of bypass connections which pass through the unit cell 1 and are not connected to any of the circuit elements 2, 3, 4 and 5.

Examples of logic circuits formed in the basic unit cell of Fig. 1 will now be explained.

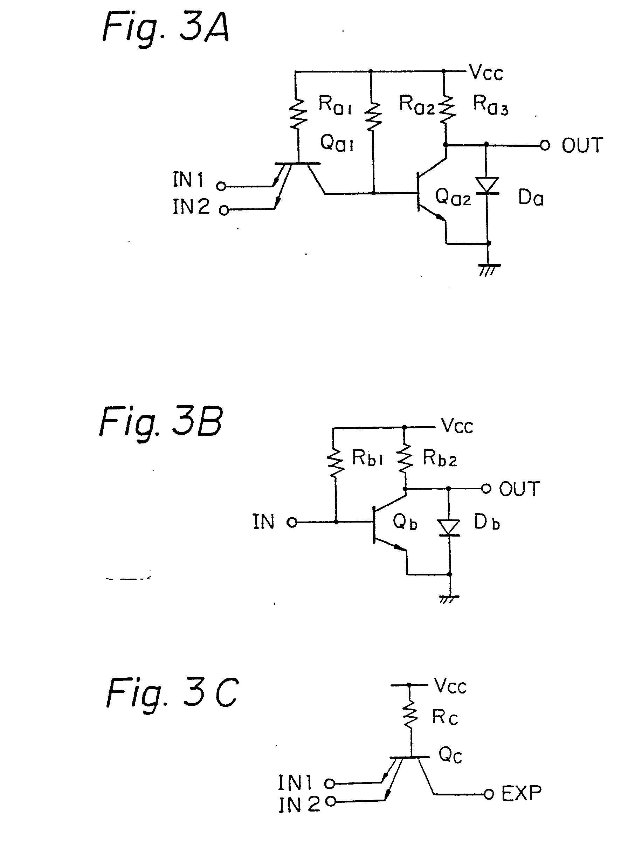

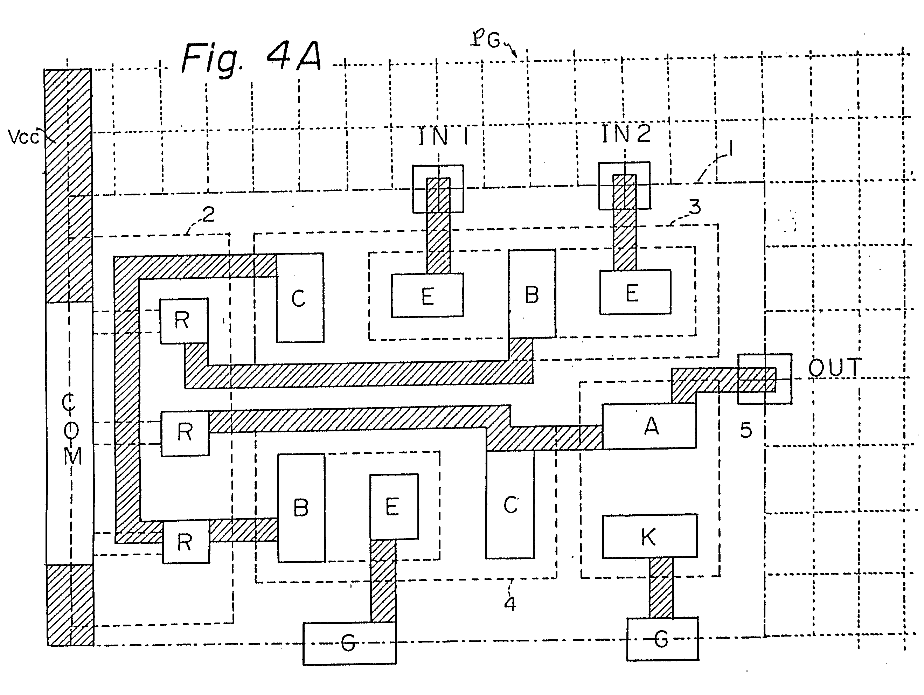

Fig. 3A is a circuit diagram of a two-input NAND gate circuit, which is formed in the basic unit cell of Fig. 1, and Fig. 4A is a layout diagram illustrating the circuit of Fig. 3A. As illustrated in Fig. 3A, the two-input NAND gate circuit comprises three resistors $R_{a1}$, $R_{a2}$ and $R_{a3}$ which are formed in the element 2 of Fig. 1, a two-emitter transistor $Q_{a1}$ which is formed in the element 3 of Fig. 1, a transistor $Q_{a2}$ which is formed in the element 4 of Fig. 1, and a diode $D_a$ which is formed in the element 5 of Fig. 1. In other words, all the circuit elements of Fig. 1 are used. In this case, interconnections between the circuit elements are illustrated as right-hatched portions in Fig. 4A. It should be noted that the interconnections are arranged independent from any grid.

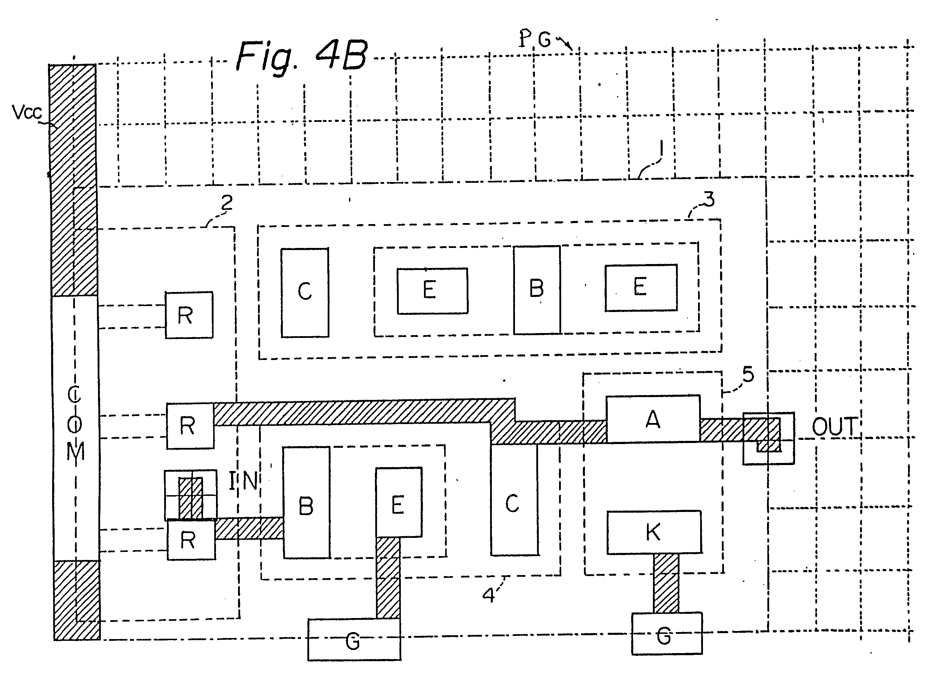

Fig. 3B is a circuit diagram of an inverter circuit, which is also formed in the basic unit cell of Fig. 1, and Fig. 4B is a layout diagram illustrating the circuit of Fig. 3B. As illustrated in Fig. 3B, the inverter circuit comprises two resistors $R_{b1}$ and $R_{b2}$ which are formed in the element 2 of Fig. 1, a transistor $Q_b$ which is formed in the element 4 of Fig. 1, and a diode $D_b$ which is formed in the element 5 of Fig. 1. Therefore, the element 3 of Fig. 1 is unused. In this case, interconnections between the circuit elements are illustrated as right-hatched portions in Fig. 4B.

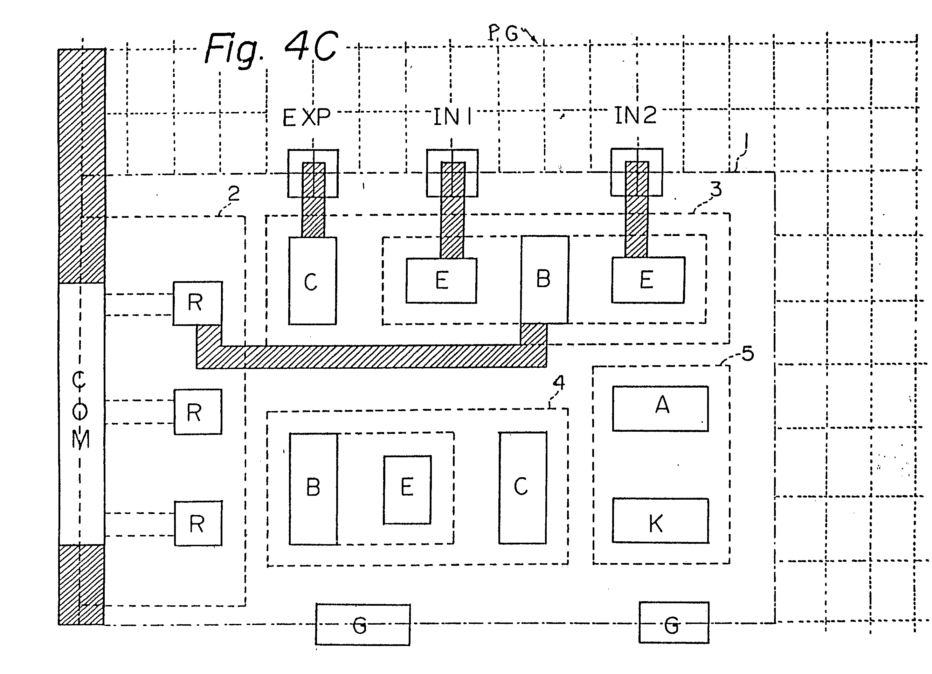

Fig. 3C is a circuit diagram of a two-input AND expander circuit, which is also formed in the basic unit cell of Fig. 1, and Fig. 4C is a layout diagram illustrating the circuit of Fig. 3C. As illustrated in Fig. 3C, the two-input AND expander circuit comprises a resistor $R_c$ which is formed in the element 2 of Fig. 1 and a two-emitter transistor $Q_c$ which is formed in the element 3 of Fig. 1. Therefore, the elements 4 and 5 of Fig. 1 are unused. In this case, interconnections between the circuit elements are illustrated as right-hatched portions in Fig. 4C.

Thus, the wasted areas of the unit cells of Figs. 4A, 4B and 4C are smaller than that of the unit cell of Fig. 1 which is unused. However, in the present invention, even when the wasted areas are small, bypass connections can be arranged. In Figs. 4A, 4B and 4C, Vcc indicates a power supply line which is formed by a first wiring layer.

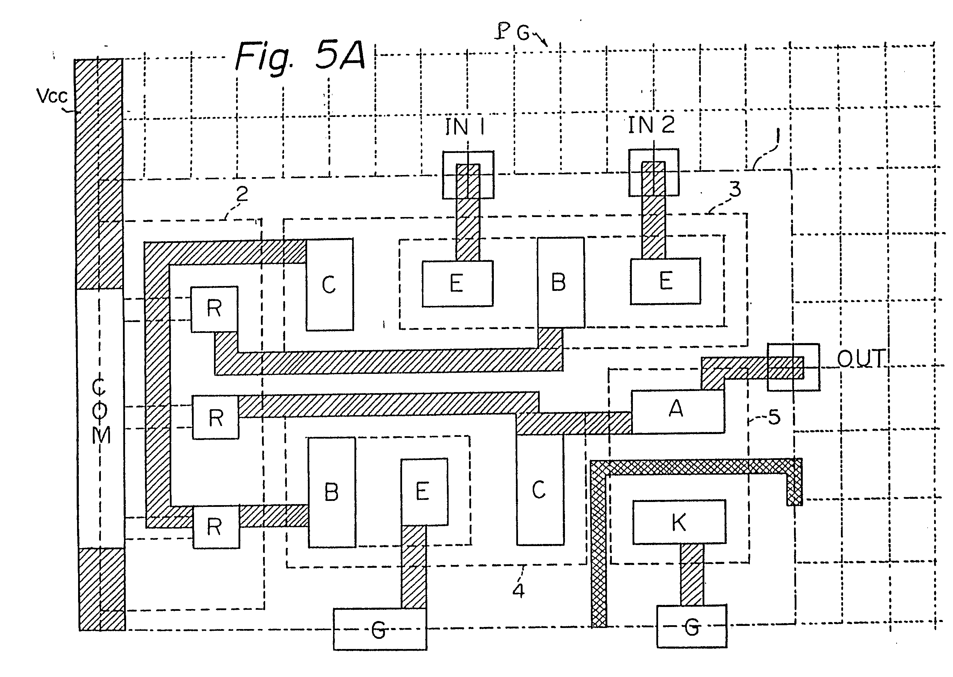

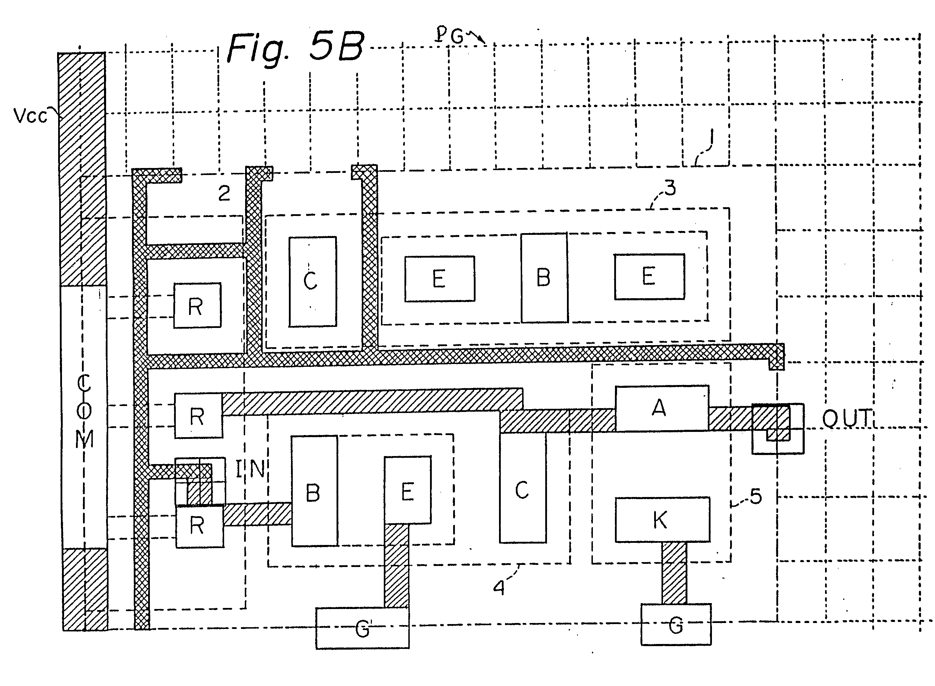

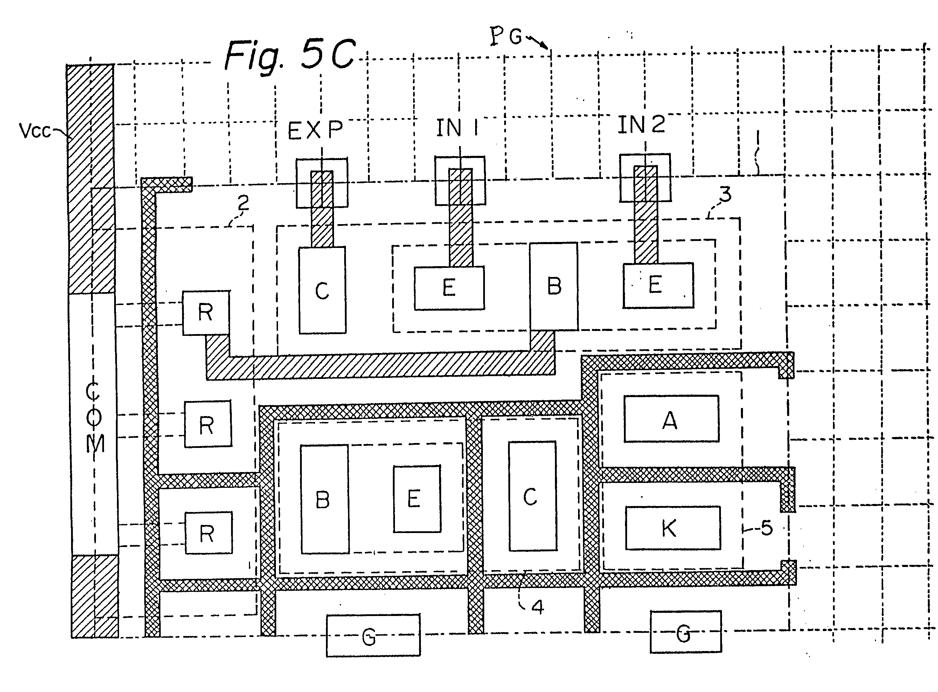

Figs. 5A, 5B and 5C are layout diagrams of the logic circuits of Figs. 3A, 3B and 3C, respectively, including bypass connections, according to the present invention. In Figs. 5A, 5B and 5C, cross-hatched portions, which indicate bypass connections, are added to Figs. 4A, 4B and 4C, respectively. As illustrated in Figs. 5A, 5B and 5C, the right-hatched portions indicate interconnections, and the larger cross-hatched portions indicate bypass connections.

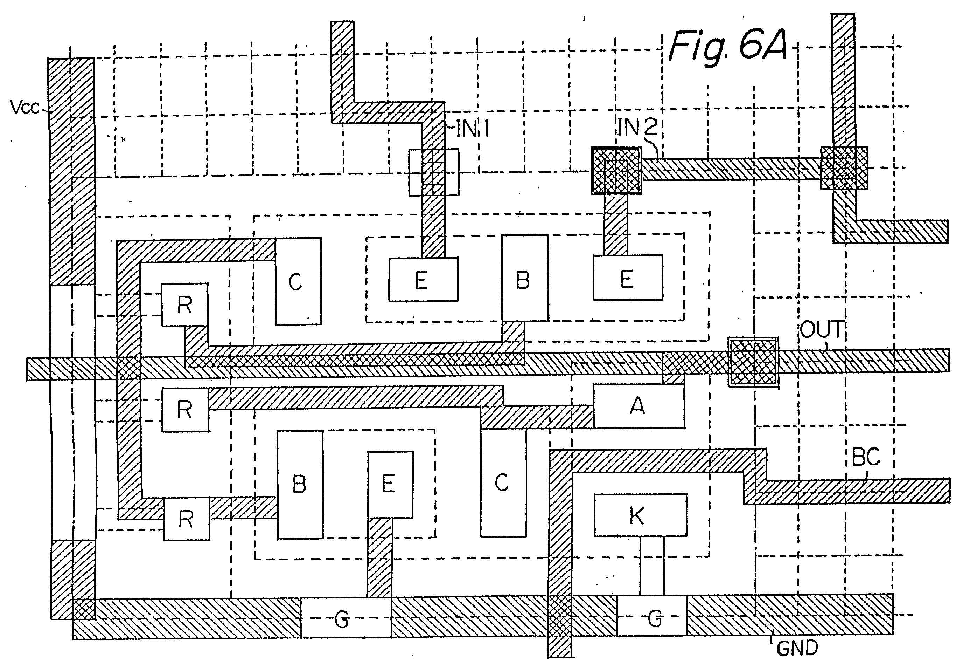

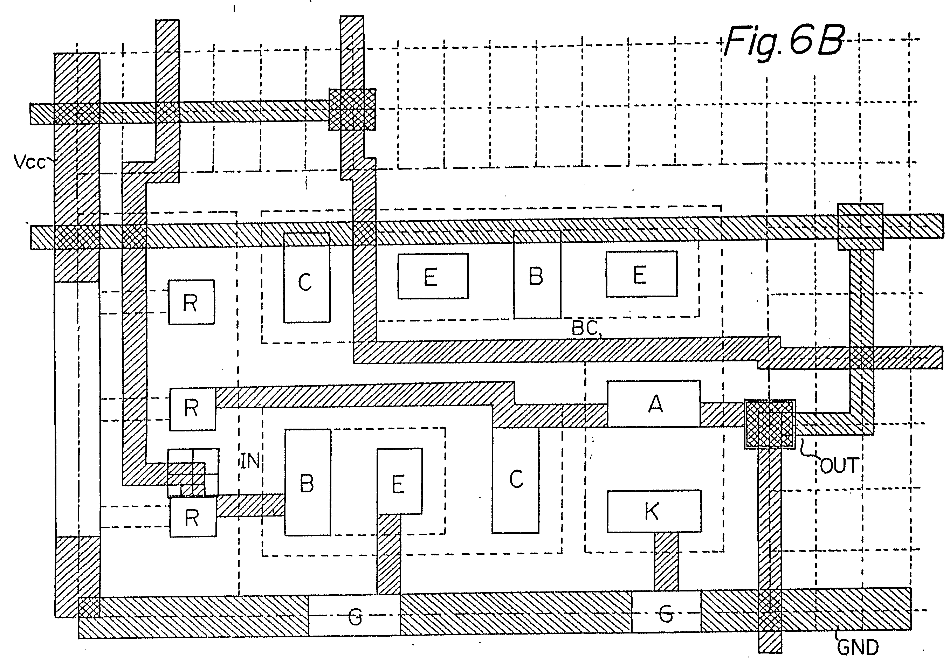

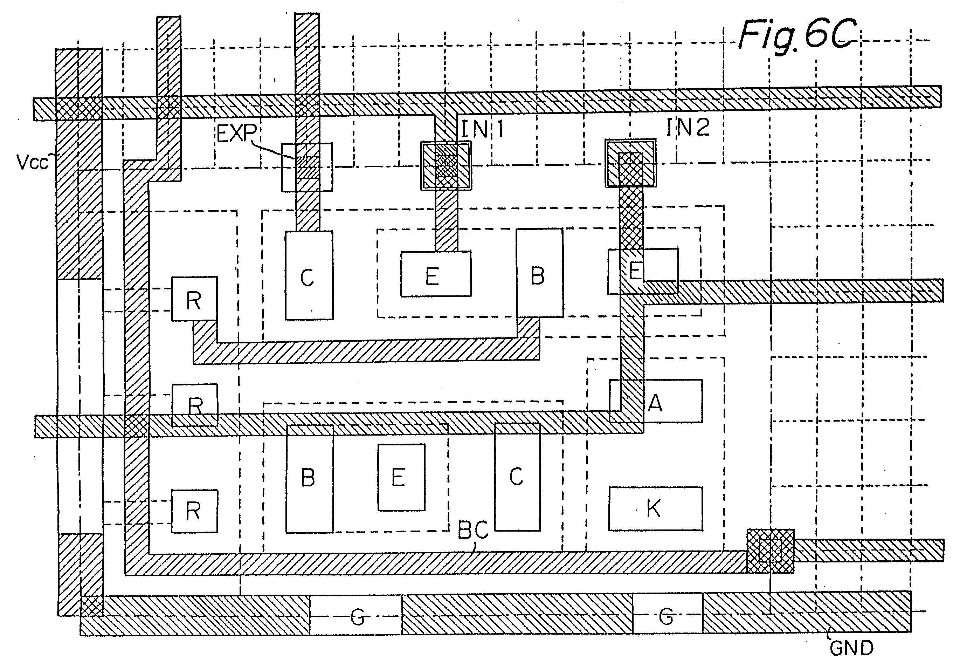

In Figs. 6A, 6B and 6C, actual external connections, interconnections, bypass connections, a power supply line (Vcc) and a ground line are present in the layout diagrams of Figs. 4A, 4B and 4C (Figs. 5A, 5B and 5C), respectively. In these figures, a right-hatched portion indicates a first wiring layer, while a left-hatched portion indicates a second wiring layer. Square cross-hatched portions indicate pads which are positioned in windows or through holes for connecting the first wiring layer and the second wiring layer. There are cross-hatched portions in which the first wiring layer is superposed on the second layer; however, the two layers are actually electrically isolated by an insulating layer (not shown) therebetween.

In Figs. 6A, 6B and 6C, GND indicates a ground line which is formed by the second wiring layer.

In Fig. 6A, a bypass connection BC which is formed by the first wiring layer passes through the unit cell.

In Fig. 6B, a bypass connection BC, which is also formed by the first wiring layer, passes through the unit cell and is connected to the second wiring layer in the external connection area.

In Fig. 6C, a bypass connection BC, which is formed by the first wiring layer, passes through the unit cell and is connected to the second wiring layer at the edge portion of the unit cell.

Fig. 7 is a layout diagram illustrating a unit cell combination according to the present invention. In Fig. 7, four unit cells 11, 12, 13 and 14, which are similar to the basic unit cell 1, are shown. All the circuit elements within the unit cells are symmetrical with regard to the lines I—I and the lines II—II. In addition, there are no spaces between the unit cells 11, 12, 13 and 14, which provides a high integration density of an LSI. In such unit cell combinations, bypass connections which serve as external connections of the prior art are important.

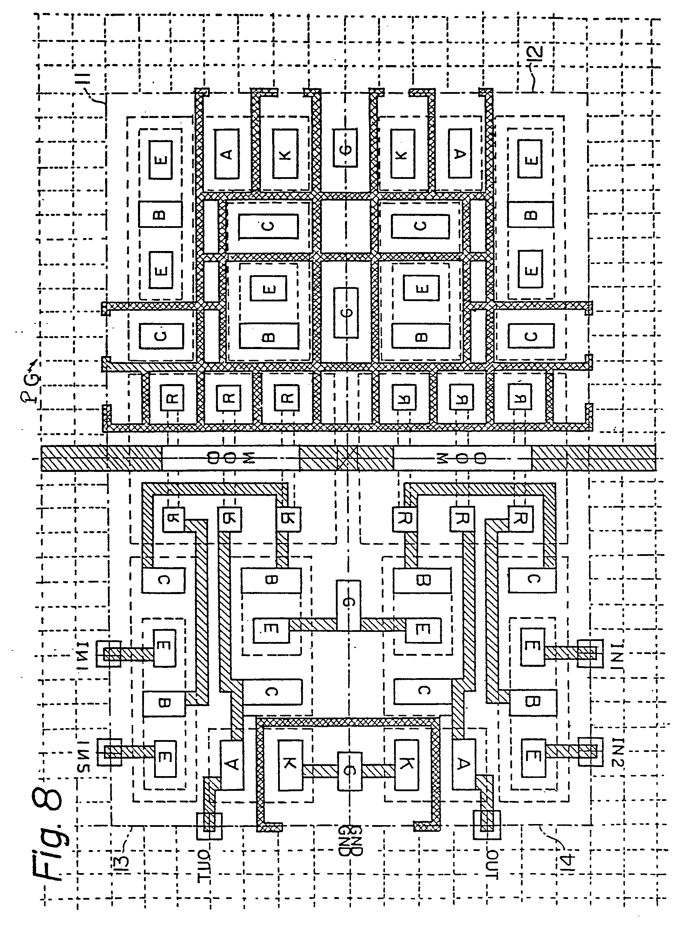

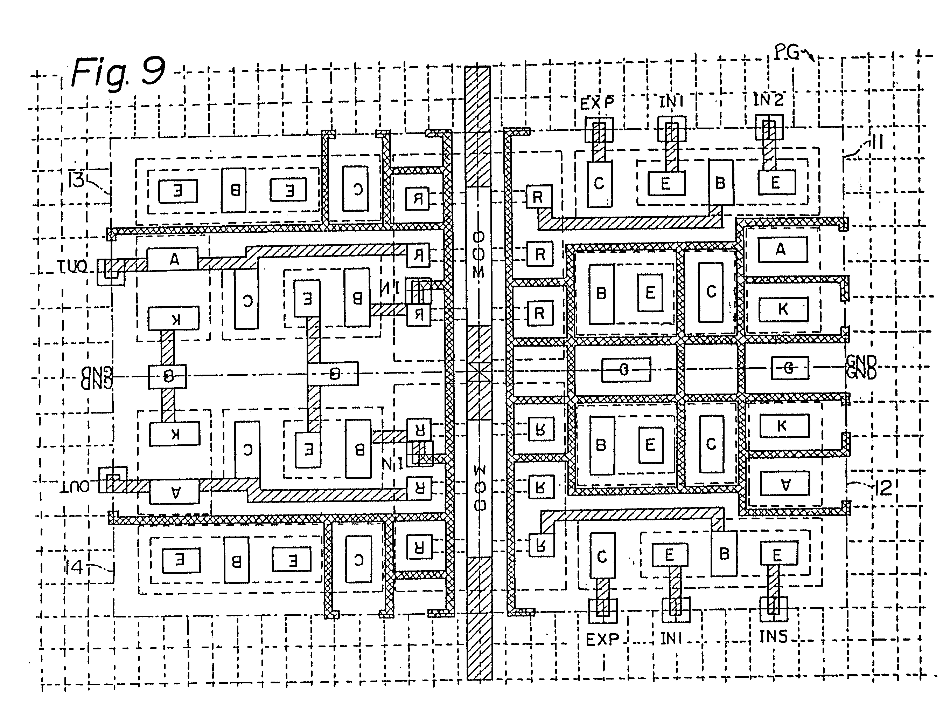

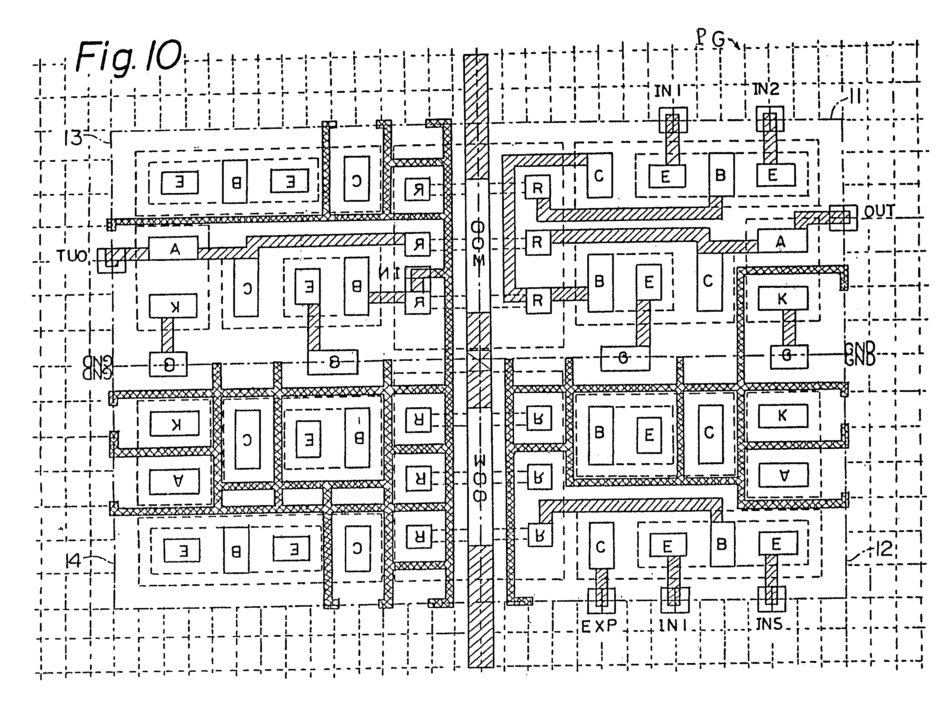

Figs. 8, 9 and 10 illustrate three examples of Fig. 7, including interconnections and bypass connections according to the present invention. In Fig. 8, the unit cells 11 and 12 are the same as that of Fig. 2 and the unit cells 13 and 14 are the same as that of Fig. 5A. Similarly, in Fig. 9, the unit cells 11 and 12 are the same as that of Fig. 5C and the unit cells 13 and 14 are the same as that of Fig. 5B. In addition, in Fig. 10, the unit cells 11, 12, 13 and 14 are the same as those of Figs. 5A, 5C, 5B and 2, respectively. In all the figures, some bypass connections of one of the unit cells are connected to bypass connections of another unit cell, due to the symmetrical arrangement of the unit cells. Therefore, such bypass connections save external connections which connect unit cells to each other and, accordingly, the semiconductor device including such unit cells with a high integration density can be obtained.

In Figs. 7 through 10, a four-unit cell combination is shown. However, it should be noted that any other combination, such as an eight unit cell combination or a sixteen unit cell combination, can be easily obtained.

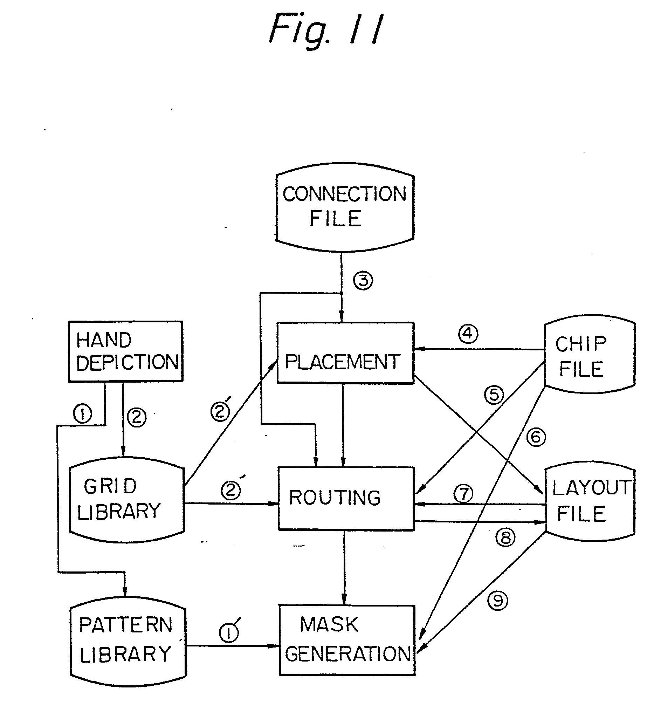

Fig. 11 is a flow diagram illustrating steps of a computer aided design according to the present invention. In the step of "Hand depiction", a basic unit cell including common circuit elements and interconnections is determined by the designer. As a result, information "1" with regard to the interconnections which correspond to Fig. 4A, 4B or 4C is stored in a pattern library, while information "2" with regard to bypass area for bypass connections which correspond to Fig. 5A, 5B or 5C is stored in a grid library. On the other hand, a connection file is used for storing a custom-made logic circuit.

In the step of "Placement", actual external connections between the unit cells and actual bypass connections within the unit cells are determined in accordance with the bypass informations "2'" from the grid library, information "3" from the connection file, information "4" for indicating an arrangement of unit cells from a chip file. Next, in the step of "Routing", a layout pattern including unit cells, interconnections, external connections, bypass connections and other connections is determined in accordance with the bypass information "2'" from the grid library, the arrangement information "5" from the chip file, information "7" from a layout file which stores the result of the step "Placement", which correspond to Fig. 6A, 6B or 6C. Next, in the step of "Mask generation", a mask for manufacturing an LSI is formed in accordance with information "1'" with regard to unit cells and actual interconnections and information "9" with regard to external connections and bypass connections. After that, the data with regard to the mask is stored in a mask pattern file (not shown).

As explained hereinbefore, the semiconductor device (LSI) manufactured by using a master-slice technology according to the present invention has such advantage that a high integration density thereof can be obtained, because bypass connections are arranged within wasted areas of each of the unit cells and, accordingly, external connections, which are arranged outside the unit cells, are reduced compared with those of the prior art. In particular, in a symmetrical arrangement of unit cells without space therebetween, such bypass connections are important, since the area for external connections is small.

**Claims**

1. A semiconductor device (Figures 5A to 5C) manufactured by master-slice technology comprising: a cell array consisting of a plurality of unit cells (a) each of which includes circuit elements (2, 3, 4, 5); interconnections within some at least of the unit cells (1), which connect the circuit elements of a unit cell to each other; and external connections outside the unit cells, which connect the unit cells to each other, the external connections being formed in alignment with selected lines from a first predetermined pattern by using some external connection area lying outside the unit cells; the device further comprising bypass connections within some at least of the unit cells for connecting others of the unit cells to each other, the bypass connections in each unit cell using unallocated cell area and being formed in alignment with selected lines from a further predetermined pattern; the device being characterised in that: the unallocated cell area is a portion of a cell wherein circuit elements may simultaneously be used for forming an active unit cell; and in that the first predetermined pattern and the further predetermined pattern are formed in alignment with selected lines of a first predetermined grid (PG) and with a further predetermined grid, respectively, which do not coincide.

2. A device according to claim 1, wherein the said further predetermined grid of each of the unit cells is determined by the arrangement of circuit elements thereof.

3. A device according to claim 1 or 2, wherein two or more the unit cells are arranged without space therebetween (11, 12, 13, 14, Figures 7 to 10).

4. A device according to claim 3, wherein two or more of the unit cells are arranged symmetrically with each other (11, 12, 13, 14, Figures 7 to 10).

5. A device according to any of claims 1 to 4, wherein the said further predetermined grid is determined with the aid of a computer.

6. A device according to any preceding claim, wherein the interconnections between circuit elements, the bypass connections and the external connections are made by at least two layers of metal wiring, each layer separated and insulated from its neighbouring layer by a nonconducting layer, electrical connections between the said wiring layers being made only at predetermined points.

7. A device according to any preceding claim, wherein the said bypass connections formed in alignment with selected lines from the further predetermined grid within a unit cell are arranged to pass through gaps between connecting pads of the circuit elements within the unit cell.

## Revendications

1. Dispositif semi-conducteur (figures 5A à 5C) fabriqué par une technologie de circuits "passe partout" comprenant un réseau de cellules consistant en plusieurs cellules unitaires (a) comprenant chacune des éléments de circuit (2, 3, 4, 5); des interconnexions dans certaines au moins des cellules unitaires (1) connectant entre eux les éléments de circuit d'une cellule unitaire, et des connexions extérieures en dehors des cellules unitaires connectant les cellules unitaires entre elles, les connexions extérieurs étant formées en alignement avec des lignes sélectionnées d'une première configuration prédéterminée en utilisant une certaine surface de connexions extérieures située en dehors des cellules unitaires; le dispositif comportant en outre des connexions de dérivation dans certaines au moins des cellules unitaires pour connecter entre elles d'autres des cellules unitaires, les connexions de dérivation dans chaque cellule unitaire utilisant une surface de cellules non-affectées et étant formées en alignement avec des lignes sélectionnées d'une autre configuration prédéterminée; le dispositif étant caractérisé en ce que la surface de cellules non affectée est une partie d'une cellule dans laquelle des éléments de circuits peuvent être utilisés simultanément pour former une cellule unitaire active et en ce que la première configuration prédéterminée et l'autre configuration prédéterminée sont formées en alignement avec des lignes sélectionnées d'une première grille prédéterminée (PG) et avec une autre grille prédéterminée respectivement qui ne coïncident pas.

2. Dispositif selon la revendication 1, dans lequel ladite autre grille prédéterminée de chacune des cellules unitaires est déterminée par la disposition de ses éléments de circuit.

3. Dispositif selon la revendication 1 ou 2, dans lequel deux ou plusieurs des cellules unitaires sont disposées sans espace entre elles (11, 12, 13, 14, figures 7 à 10).

4. Dispositif selon la revendication 3, dans lequel deux ou plusieurs des cellules unitaires sont disposées symètriquement entre elles (11, 12, 13, 14, figures 7 à 10).

5. Dispositif selon l'une quelconque des revendications 1 à 4, dans lequel ladite autre grille prédéterminée est déterminée à l'aide d'un calculateur.

6. Dispositif selon l'une quelconque des revendications précédentes, dans lequel les interconnexions entre des éléments de circuit, les connexions de dérivation et les connexions extérieures sont faites par au moins deux couches de connexions métalliques, chaque couche étant séparée et isolée de la couche voisine par une couche non-conductrice, des connexions électriques entre lesdites couches de connexions n'étant faites qu'en des points prédéterminés.

7. Dispositif selon l'une quelconque des revendications précédentes, dans lequel lesdites connexions de dérivation formées en alignement avec des lignes sélectionnées de ladite autre grille prédéterminée dans une cellule unitaire sont disposées pour passer dans des intervalles entre des surfaces de connexions des éléments de circuits dans la cellule unitaire.

## Patentansprüche

1. Halbleitervorrichtung (Figuren 5A bis 5C), welche nach der Masterslice-Technologie hergestellt sind, mit: einer Zellenanordnung, welche aus einer Mehrzahl von Einheitszellen (1) besteht, von denen jede Schaltungselemente (2, 3, 4, 5) umfaßt, Zwischenverbindungen innerhalb wenigstens einiger der Einheitszellen (1), welche die Schaltungselemente einer Einheitszelle miteinander verbinden, und äußeren Anschlüssen außerhalb der Einheitszellen, welche die Einheitszellen miteinander

**0 021 661**

verbinden und welche ausgerichtet mit ausgewählten Linien eines ersten vorbestimmten Musters gebildet sind, unter Verwendung einiger äußerer Anschlußbereiche, welche, außerhalb der Einheitszellen liegen, ferner mit Beipaß-Verbindungen innerhalb wenigstens einiger der Einheitszellen zur Verbindung anderer der Einheitszellen miteinander, wobei die Beipaß-Verbindungen in jeder Einheitszelle einen nicht zugeordneten Zellenbereich verwenden und in Ausrichtung mit ausgehählten Linien eines weiteren vorbestimmten Musters gebildet sind, dadurch gekennzeichnet, daß der nicht zugeordnete Zellenbereich ein Abschnitt einer Zelle ist, in welchem Schaltungselemente gleichzeitig zur Bildung einer aktiven Einheitszelle verwendet sein können, und daß das erste vorbestimmte Muster und die weiteren vorbestimmten Muster in Ausrichtung mit ausgewählten Linien eines ersten vorbestimmten Gitters (PG) bzw. mit einem weiteren vorbestimmten Gitter gebildet sind, welche nicht koinzidieren.

2. Vorrichtung nach Anspruch 1, bei welcher das genannte weitere vorbestimmte Gitter jeder der Einheitszellen durch die Anordnung seiner Schaltungselemente bestimmt ist.

3. Vorrichtung nach Anspruch 1 oder 2, bei welcher zwei oder mehr Einheitszellen ohne Abstand zwischen einander (11, 12, 13, 14, Figuren 7 bis 10) angeordnet sind.

4. Vorrichtung nach Anspruch 3, bei welcher zwei oder mehr Einheitszellen symmetrisch zueinander (11, 12, 13, 14, Figuren 7 bis 10) angeordnet sind.

5. Vorrichtung nach einem der Ansprüche 1 bis 4, bei welcher das weitere vorbestimmte Gitter mit Hilfe eines Computers bestimmt ist.

6. Vorrichtung nach einem der vorhergehenden Ansprüche, bei welcher die Zwischenverbindungen zwischen den Schaltungselementen, den Beipaß-Verbindungen und den äußeren Verbindungen mit Hilfe von wenigstens zwei Metalldrahtschichten hergestellt sind, wobei jede Schicht von der ihr benachbarten Schicht getrennt und mit Hilfe einer nicht leitenden Schicht isoliert ist und die elektrischen Verbindungen zwischen den Verdrahtungsschichten lediglich an vorbestimmten Punkten hergestellt sind.

7. Vorrichtung nach einem der vorhergehenden Ansprüche, dadurch gekennzeichnet, daß die Beipaß-Verbindungen in Ausrichtung mit ausgewählten Linien des weiteren vorbestimmten Gitters innerhalb einer Einheitszelle ausgerichtet und so angeordnet sind, daß sie durch die Spalten zwischen den Verbindungsstellen der Schaltelemente innerhalb der Einheitszelle hindurch gehen.

Fig. I

Fig. 2

*Fig. 3A*

*Fig. 3B*

*Fig. 3 C*

Fig. 4A

Fig. 4B

Fig. 4C

*Fig. 5A*

*Fig. 5B*

PG

Vcc

COM

Vcc

2

3

R

C

E  B  E

R

A

OUT

IN

B  E

C

K

5

R

4

G

G

Fig. 5C

Fig. 6A

*Fig.6B*

Fig.6C

Fig. 7

Fig. 8

Fig. 9

Fig. 10

*Fig. 11*